# EUROPEAN PATENT SPECIFICATION

(11) **EP 0 382 415 B1**
(45) Date of publication and mention of the grant of the patent: **28.09.1994**
(21) Application number: 90301089.0
(22) Date of filing: 02.02.1990
(51) Int. Cl.: H01L 27/118

(54) **Semiconductor integrated circuit devices**
Integrierte Halbleiterschaltungsanordnungen
Dispositifs de circuit intégré semi-conducteur

(30) Priority: 09.02.1989 JP 30578/89; 09.02.1989 JP 30579/89; 10.02.1989 JP 31977/89; 16.02.1989 JP 37003/89
(43) Date of publication of application: 16.08.1990
(73) Proprietor: SONY CORPORATION, Tokyo 141 (JP)
(72) Inventor: Moriuchi, Shigeru, c/o Patents Division, Shinagawa-ku, Tokyo 141 (JP); Takeda, Masashi, c/o Patents Division, Shinagawa-ku, Tokyo 141 (JP); Mogi, Takayuki, c/o Patents Division, Shinagawa-ku, Tokyo 141 (JP); Anmo, Hiroaki, c/o Patents Division, Shinagawa-ku, Tokyo 141 (JP)
(74) Representative: Cotter, Ivan John

(56) References cited:
- WO-A-89/04553
- DE-A- 3 634 850
- IBM TECHNICAL DISCLOSURE BULLETIN, vol. 27, no. 11, April 1985, pages 6727-6728, Armonk, NY, US; "Diagonal layout of gate array"
- IEEE JOURNAL OF SOLID-STATE CIRCUITS, vol. SC-21, no. 5, October 1986,pages 727-731, IEEE, New York, NY, US; T. NISHIMURA et al.: "A bipolar 18K-gatevariable size cell masterslice"
- ELECTRONICS, vol. 59, no. 30, September 1986, pages 55-59, New York, US;"Fairchild's radical process for building bipolar VLSI"
- ELECTRONICS, vol. 61, no. 3, 4th February 1988, pages 63-64, New York, US; S.WEBER: "LSI logic arrays boost both drive and density"

## Description

This invention relates to masterslice semiconductor integrated circuit devices.

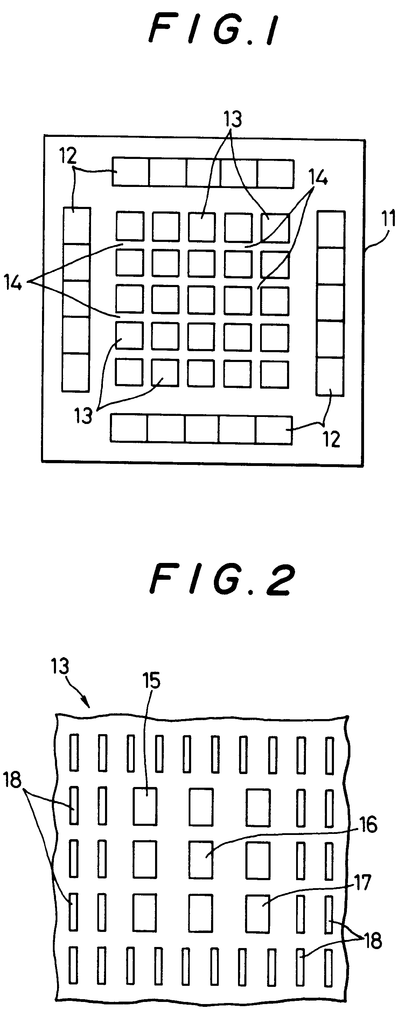

A first example of a semiconductor integrated circuit device using the so-called masterslice approach, and which includes a bipolar transistor element as a basic element, is shown in Figure 1. In this device, peripheral cells 12 are arranged in a peripheral portion of a semiconductor chip 11, and internal cells 13 as island regions are surrounded by the peripheral cells 12. Therefore, portions around the internal cells 13 form wiring regions 14.

In one island-like internal cell 13, npn bipolar transistor elements 15, pnp bipolar transistor elements 16, MIS capacitive elements 17, resistive elements 18 formed by impurity diffusion layers, and the like are formed, as shown in Figure 2. In each internal cell 13, the elements 15 to 18 and the like are optimally arranged depending on the proposed application.

A masterslice including a bipolar transistor as a basic element is not limited to the bipolar masterslice described above, but can be exemplified by a Bi-Mos masterslice, or a Bi-CMOS masterslice (see Nikkei Electronics, 18 April 1988 (No. 445), pages 227 - 241). All these masterslices have the structures shown in Figures 1 and 2.

In the first example described above, each internal cell 13 is optimized for a specific purpose, and does not have versatility. The region of the internal cell 13 and the wiring regions 14 are fixed. For this reason, systematic, optimal circuit design cannot be achieved, and wasteful regions are formed.

In addition, the wiring regions 14 are regions only for wiring, and the elements 15 to 18 are not formed in the wiring regions 14. Therefore, a high integration level cannot be obtained.

As is apparent from Figure 2, the bipolar transistors 15 and 16 are not generally formed to be adjacent to the resistive elements 18. For this reason, the layout of the elements 15 to 18 cannot comply with a layout of the circuit design. Therefore, it is not easy to obtain an optimum circuit arrangement.

In addition, when each resistive element 18 is formed as a diffusion resistor in a semiconductor substrate, the integration level of the other basic elements 15 to 17 is naturally low.

When the resistive elements 18 are formed as diffusion resistors in the semiconductor substrate, the layout of the resistive elements 18 and their resistances cannot be optimized in individual circuits. For example, several resistive elements 18 are required in a masterslice corresponding to one resistive element in a circuit layout. As a result, the region of the resistive elements 18 and the region of the other basic elements 15 to 17 are unbalanced, and effective utilization of the total region for the basic elements 15 to 18 is prevented. Since the arrangement of the resistive elements 18 and their resistances cannot be optimized in the individual circuits, it is not easy to design the circuit layout.

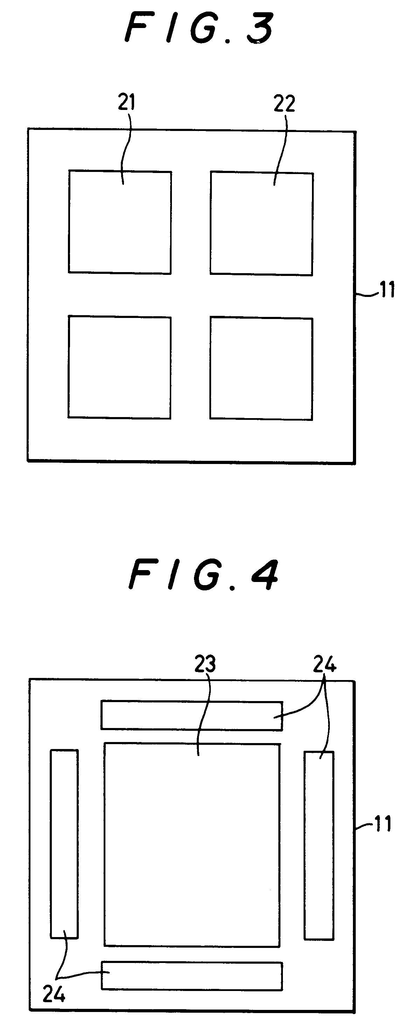

Other masterslices shown in Figures 3 and 4 are examples including bipolar transistor elements and MOS transistor elements as basic elements.

The second example shown in Figure 3 includes bipolar transistor elements as major elements. Blocks of bipolar transistor elements 21 forming an operational amplifier, and blocks of MOS transistor elements 22 forming an analogue switch are formed on a semiconductor chip 11.

The third example shown in Figure 4 comprises MOS transistor elements as major elements. A block of MOS transistor elements 23 forming a gate array, and blocks of bipolar transistor elements 24 forming an input/output circuit are formed on a semiconductor chip 11.

Although the second and third examples are optimized for specific application purposes, the ratio of the number of bipolar transistor elements 21 and 24 to the number of MOS transistor elements 22 and 23 is fixed. For this reason, versatility in circuit design is limited in the second and third examples.

A Bi-CMOS device or the like generally comprises at least a MOS transistor element, a MIS capacitive element, and a resistive element.

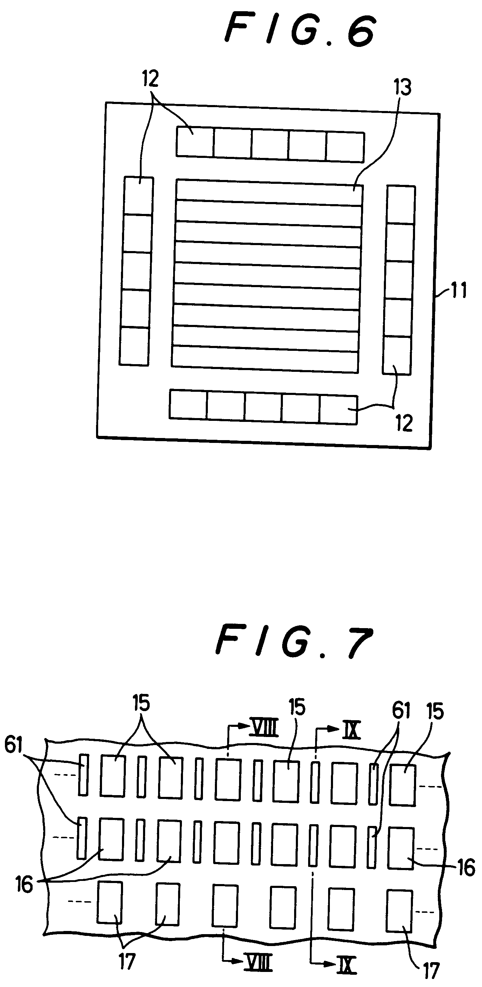

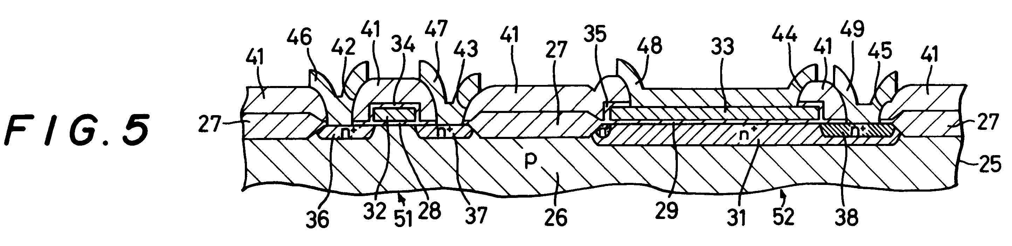

Figure 5 shows a fourth example of a semiconductor device obtained by wiring a Bi-CMOS masterslice. To manufacture this semiconductor device, a p type well 26 is formed in an n type Si substrate 25, and an SiO₂ film 27 is then formed as a field oxide. The surface of the Si substrate 25 is oxidized to form an SiO₂ film 28 serving as a gate oxide, and an SiO₂ film 29 serving as an insulator film of a MIS capacitive element. A resist film (not shown) is patterned, and an impurity is ion-implanted to form an n⁺ type region 31 serving as one electrode of the MIS capacitive element.

A first poly-Si layer is patterned to form a poly-Si layer 32 serving as a gate electrode and a poly-Si layer 33 serving as the other electrode of the MIS capacitive element. The surfaces of the poly-Si layers 32 and 33 are oxidized to form SiO₂ films 34 and 35. In this state, an impurity is ion-implanted to form n⁺ type regions 36 and 37 serving as source/drain regions and an n⁺ type region 38 serving as an electrode take-off connection of the n type region 31. A second poly-Si layer (not shown) is patterned to form resistive elements at predetermined positions.

Thereafter, an interlayer insulator 41 and electrode windows 42 to 45 are formed, and Al wiring layers 46 to 49 are patterned to form a MOS transistor element 51, a MIS capacitive element 52, and a resistive element (not shown).

Another integrated circuit device, having features corresponding to those in the pre-characterizing part of claim 1, is disclosed in IBM Technical Disclosure Bulletin, vol. 27, no. 11, April 1985, pp 6727-6728.

According to the present invention there is provided a masterslice semiconductor integrated circuit device comprising: a plurality of rows of bipolar transistor elements, interlayer insulation including windows through which electrical connections are made to those of said transistor elements used in the circuit, regions serving as wiring regions overlaying those of said transistor elements not used in the circuit, and
in a central region of the device, resistor elements arranged alternately with said transistor elements in the rows, wherein the transistor elements in one of the rows are npn bipolar transistor elements, and the transistor elements in another of the rows are pnp bipolar transistor elements.

Such an integrated circuit, but without the rows being of npn and pnp transistor elements, is disclosed in patent application number WO89/04553 (EP-A-0 349 605) which is comprised in the state of the art pursuant to Article 54(3) EPC and as such is not relevant to the question of inventive step (Article 56 EPC).

In embodiments of the present invention, electrical connections to bipolar transistor elements are formed through electrode windows, and regions on bipolar transistor elements which are not used are used as wiring regions, thereby freely determining an active region and the wiring region. With this arrangement, circuit design can be optimized, and wasteful regions can be eliminated. Since the regions on the bipolar transistor elements which are not used serve as wiring regions, a specific region for wiring only need not be formed. For this reason, bipolar transistor elements can be arranged in the region previously used only for wiring, and a high integration level can be obtained.

The invention will now be described by way of example with reference to the accompanying drawings, throughout which like parts are referred to by like references, and in which:
Figure 1 is a plan view of a first known example;
Figure 2 is an enlarged plan view of part of the first example;
Figures 3 and 4 are plan views of second and third known examples, respectively;
Figure 5 is a side sectional view of a fourth known example;
Figure 6 is a plan view of an embodiment of the present invention and corresponds to Figure 1;
Figure 7 is an enlarged plan view of part of the embodiment and corresponds to Figure 2; and
Figures 8 and 9 are enlarged side sectional views along the lines VIII - VIII and IX - IX respectively of Figure 7.

The embodiment, which is a semiconductor integrated circuit device using a bipolar masterslice approach will be described with reference to Figures 6 to 9.

As shown in Figure 6, peripheral cells 12 are arranged in a peripheral portion of a semiconductor chip 11 in the embodiment as in the example of Figure 1. However, internal cells 13 are in contact with each other, with no gaps. Therefore, a region for wiring only is not provided in the embodiment.

As shown in Figure 7, each array of the internal cell 13 comprises npn bipolar transistor elements 15 and resistive elements 61, pnp bipolar transistor elements 16 and resistive elements 61, or MIS capacitive elements 17. These arrays are formed repeatingly to form the entire internal cell 13.

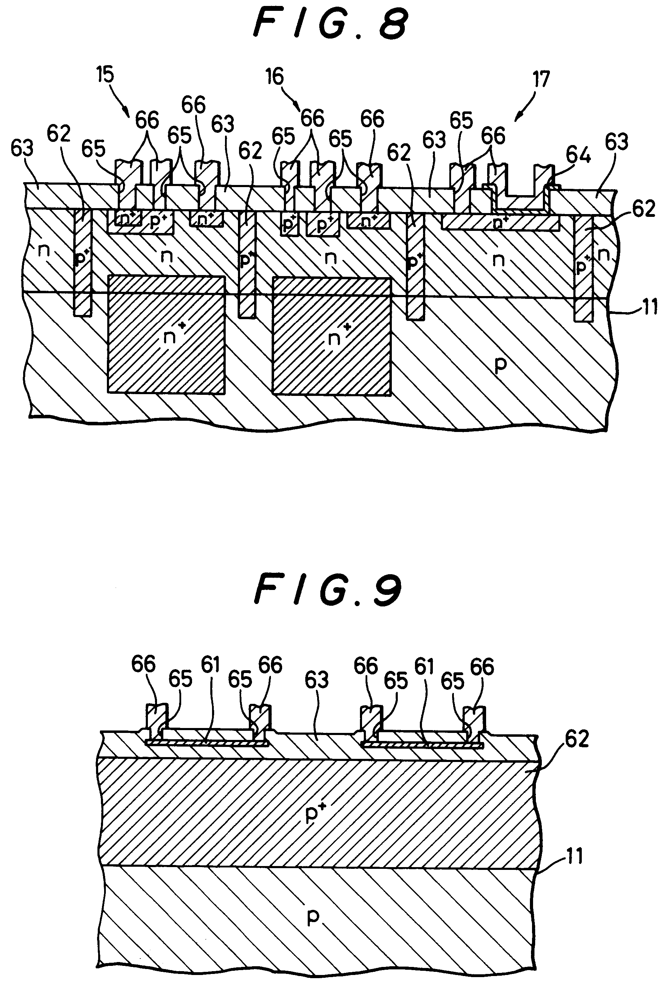

As is apparent from Figure 8, only isolation areas 62 are formed between each array of the internal cells 13, the usual wiring regions having been eliminated.

As shown in Figure 9, the resistive elements 61 are located on the isolation areas 62 between the adjacent npn bipolar transistor elements 15 and between the adjacent pnp bipolar transistor elements 16, and are formed by a poly-Si layer in an interlayer insulator 63.

The masterslice of the embodiment is manufactured to a state wherein only a dielectric film 64 of a MIS capacitive element 17 is exposed from the interlayer insulator 63.

A wiring step is started from openings of electrode windows 65 for the elements 15 to 17 and 61 which are to be used in a circuit. Wiring layers 66 pass over the isolation area 62 and the elements 15 to 17 and 61 which do not have any electrode windows because these elements are not used in the circuit.

The embodiment exemplifies the semiconductor integrated circuit device of bipolar masterslice approach. However, the present invention is also applicable to a semiconductor integrated circuit device of Bi-MOS masterslice approach which comprises internal cells 13 obtained by repeatingly forming elements 15 to 17 and 61 and MOS transistors, or a semiconductor integrated circuit device of a Bi-CMOS masterslice approach which has CMOS transistors in place of the MOS transistors.

## Claims

1. A masterslice semiconductor integrated circuit device comprising:
a plurality of rows of bipolar transistor elements (15, 16), interlayer insulation (63) including windows (65) through which electrical connections are made to those of said transistor elements (15, 16) used in the circuit, regions serving as wiring regions overlaying those of said transistor elements (15, 16) not used in the circuit, and
in a central region of the device, resistor elements (61) arranged alternately with said transistor elements (15, 16) in the rows, wherein the transistor elements in one of the rows are npn bipolar transistor elements (15), and the transistor elements in another of the rows are pnp bipolar transistor elements (16).

2. A device according to claim 1 further comprising a row of capacitive elements (17).

## Patentansprüche

1. Integrierte Master-slice Halbleiterschaltungsvorrichtung umfassend:
mehrere Reihen von Bipolar-Transistorelementen (15, 16), wobei eine Zwischenschicht-Isolierung (63) Fenster (65) aufweist, durch die elektrische Verbindungen mit denjenigen der Transistorelemente (15, 16) hergestellt werden, die in der Schaltung benutzt sind, wobei Gebiete als Verdrahtungsgebiete dienen, die über denjenigen der Transistorelemente (15, 16) liegen, die nicht in der Schaltung benutzt sind; und
Widerstandselemente (61) in einem mittleren Gebiet der Vorrichtung, die abwechselnd mit den Transistorelementen (15, 16) in der Reihen angeordnet sind, wobei die Transistorelemente in einer der Reihen npn Bipolar-Transistorelemente (15) sind, und die Transistorelemente in einer anderen der Reihen pnp Bipolar-Transistorelemente (16) sind.

2. Vorrichtung nach Anspruch 1 desweiteren mit einer Reihe von kapazitiven Elementen (17).

## Revendications

1. Dispositif de circuit intégré à semiconducteur sur plaquette comprenant :
une pluralité de rangées d'éléments transistors bipolaires (15, 16), une isolation intercouche (63) comportant des fenêtres (65) par lesquelles des connexions électriques sont réalisées pour ceux desdits éléments transistors (15, 16) qui sont utilisés dans le circuit, des régions servant de régions de câblage recouvrant ceux desdits éléments transistors (15, 16) qui ne sont pas utilisés dans le circuit ; et
dans une région centrale du dispositif, des éléments résistances (61) disposés, dans les rangées, de façon alternée avec lesdits éléments transistors (15, 16), les éléments transistors de l'une des rangées étant des éléments transistors bipolaires npn (15), et les éléments transistors dans une autre des rangées étant des éléments transistors bipolaires pnp (16).

2. Dispositif selon la revendication 1, comprenant en outre une rangée d'éléments condensateurs (17).
